# EUROPEAN PATENT SPECIFICATION

(11) **EP 3 599 720 B1**
(45) Date of publication and mention of the grant of the patent: **29.06.2022**
(21) Application number: 18306023.5
(22) Date of filing: 27.07.2018
(51) Int. Cl.: H03H 9/02, H03H 9/64

(54) **RESONANT CAVITY SURFACE ACOUSTIC WAVE (SAW) FILTERS**
FILTER AKUSTISCH GEKOPPELTER OBERFLÄCHENWELLENRESONATOREN
FILTRES UTILISANT DES RESONATEURS COUPLES À ONDES ACOUSTIQUES DE SURFACE

(43) Date of publication of application: 29.01.2020
(73) Proprietor: Frec'n'sys, 25000 Besançon (FR)
(72) Inventor: BALLANDRAS, Sylvain, 25000 Besançon (FR); LAROCHE, Thierry, 25000 Besançon (FR)
(74) Representative: Grünecker Patent- und Rechtsanwälte PartG mbB

(56) References cited:
- US-A- 3 970 970
- US-A- 4 054 851
- US-A1- 2009 085 430
- US-A1- 2016 261 249
- US-A1- 2018 205 362
- CROSS P S ET AL: "ACOUSTICALLY CASCADED ASW RESONATOR - FILTERS", ULTRASONICS SYMPOSIUM. PROCEED, IEEE, NEW YORK, NY, US, 1 January 1976 (1976-01-01), pages 277-280, XP008032242, ISSN: 0090-5607
- SCHWELB O ET AL: "Modelling, simulation, and design of SAW grating filters", 19881002; 19881002 - 19881005, 2 October 1988 (1988-10-02), pages 1-6, XP010075409,

## Description

The invention relates to surface acoustic wave devices for filter applications and, more particularly, to a composite substrate for surface acoustic wave filter devices.

In recent years, surface acoustic wave (SAW) devices have been employed in an increasing number of practical applications, such as filters as shown in US 3, 970,970 A and US 4,054,851 A, sensors and delay lines.

The synthesis of SAW filters requires different types of tools and allows for different types of structures to be implemented. However, the use of classical filter structures in SAW devices faces various problems, such as compactness and performance of the device.

SAW filter devices commonly use wafers made from a monolithic Quartz, LiNbO3 or LiTaO3 crystal as piezoelectric materials. However, the use of piezoelectric substrates leads to either high sensibility to temperature or weak electromechanical coupling depending on the piezoelectric material used. This results in poor performance of the filters' pass-band characteristics.

The filter performance is defined using several parameters such as bandwidth, in-band insertion loss, rejection and transition bandwidth, separating the passband and the rejection band.

Furthermore, the use of cavities for generating poles and zeros in filter transfer function is a well-known technique used systematically when developing microwave filters operating at several GHz. Such a filter requires a waveguide along which are disposed resonant elements yielding poles or zero depending the way they are connected one another (in series or in parallel). The synthesis of such filters is based on the combination of these poles and zeros providing reduced ripples in the band and a improved out-of-band rejection assuming a given coupling factor between the source and the filtering structure. In any case, the filter only consists in a series of cavities connected to one another or placed along the said waveguide and accessed either by an electric connector or directly via the edges of the waveguide. For SAW devices, a conversion has to be achieved from electromagnetic to acoustic waves and vice versa to provide the electromagnetic filtered signal. In between, electrode structures are combined in a way that resonance can be combined either electrically or acoustically to produce the filtering effects.

So far, presently developed solutions for SAW filters are using three kinds of architectures to achieve the filter function, mainly impedance element lattices (the so-called SAW-ladder) or longitudinally coupled resonator filters (LCRF) or double-mode SAW (DMS) filters both based on coupling IDTs using gratings operating close to the Bragg condition. However these
approaches generally allow for two or more poles to be placed in the passband, thus resulting in non optimized performance of the device and need a relatively large footprint.

The object of the invention is to overcome the drawbacks cited previously by providing a surface acoustic wave (SAW) filter device deposited on a composite substrate with improved design for compactness, simplicity and versatility as well as good performance.

The object of the invention is achieved by a coupled cavity filter structure according to claim 1. With such a filter structure, the passband can be adjusted and at the same time filter structures with reduced footprint can be obtained compared to the above described filter structures in the art.

Whereas in the prior art use was made of Rayleigh waves, the use of a piezoelectric layer instead of a bulk substrate opens the way to use acoustic waves of a different type, thereby providing further optimization parameters. Guided shear waves can provide the highest electromechanical coupling reachable using composite substrates. They allow for accessing higher wave velocities than elliptically polarized waves with extended opportunities for thermal compensation compared to classical Rayleigh-like waves. Furthermore, the use of given combination of substrates and excitation conditions enables one to excite longitudinally polarized guided waves, yielding higher velocity than other wave types, shear waved and Rayleigh wave, with coupling in excess of 5%.

According to a variant of the invention, the inter-digitated comb electrodes of the at least one input transducer structure and one output transducer structure can be defined by the Bragg condition given by *p* = *λ* / *2, λ* being the operating acoustic wavelength of said transducer structures and p being the electrode pitch of said transducer structures. This approach enables to yield optimal dimension and excitation conditions or coupling conditions for given frequency, bandwidth and energy confinement. According to a variant of the invention, the coupled cavity filter structure can comprise further at least one Bragg mirror, located apart the input and/or output transducer structure, on the opposite side of the side where the one reflecting structure is located, in the direction of propagation of the acoustic wave. The presence of the Bragg mirror located next to the transducer structure enables to reduce losses in the structure.

According to a variant of the invention, the coupled cavity filter structure can comprise a plurality of reflecting structures, separated from each other by a gap g and positioned at a distance d and in between with respect to the input and output transducer structures, in the direction of propagation of an acoustic wave, each gap g between the reflecting structures and each gap d between a transducer structure and its adjacent reflecting structure forming an acoustic cavity. The fact that the structure has more than one reflecting structure provides a plurality of acoustic cavities in the structure. A higher number of acoustic cavities allows narrowing the transition band.

According to a variant of the invention, the dimension of each acoustic cavity of the cavity filter structure can be smaller than λ/4, in particular so that the phase velocity in the cavity is superior to the phase velocity within the reflecting structure. Such dimensions can improve the resonance conditions and thereby the performance of the filter.

According to a variant of the invention, the distance between neighbouring reflecting structures of the plurality of reflecting structures and / or the distance between a reflecting structure and a neighbouring transducer structure can be the same or different. By adapting the dimension of the gap, thus of the cavity, the filter parameters can be improved.

According to a variant of the invention, the reflecting structure or the reflecting structures can have a unitary metallic strip reflection coefficient superior to the coupling coefficient *kₛ²* of the composite substrate and of the electrodes of the transducer structure, in particular a unitary metallic strip reflection coefficient at least 1,5 time superior to the coupling coefficient *kₛ².* A higher ratio of the reflection coefficient over the coupling coefficient provides, for a given bandwidth, an essentially flat in-band transfer function and sharpend transition band, with a reduced in-band ripples effect compared to filters not satisfying the condition.

According to a variant of the invention, the input and output transducer structures can be different, in particular, the number of electrodes of each transducer structure is different. Thus the filter structure is more versatile and the structure of the transducer can be modified in order to optimize the coupling efficiency of the mode within the reflecting structures in order to obtain low insertion loss.

According to a variant of the invention, each reflecting structure can comprise at least one or more metallic strips with a pitch of the metallic strips being the same or being different to the electrode pitch of the input and output transducer structures.

Using highly reflecting structures can give more tolerance of the mirror to manufacturing variations but it also allows for shifting reflection function zeros to improve the out-band rejection.

According to a variant of the invention, the metallic strips of each reflecting structure can be electrically connected to each other. Thus a constant value of the electrical potential throughout each reflecting structure can be obtained, thereby improving the reflection coefficient of the reflecting structure at the Bragg condition.

According to a variant of the invention, the number of metallic strips of each reflecting structure of the plurality of reflecting structures can be below 30, preferentially below 20, so that the reflection coefficient of the plurality of reflecting structures is above 0,5, in particular above 0,8. Thus, the cavities confinement of the acoustic energy can be improved and mode coupling conditions can be provided in the structure.

According to a variant of the invention, the difference between the acoustic impedance of the material from the piezoelectric layer and the material from the metallic strips of the each reflecting structure of the plurality of reflecting structures can be such that the reflection coefficient of the plurality of reflecting structures is superior to 0,5, in particular superior to 0,8. By increasing the reflection coefficient, it becomes possible to reduce the size of the filter structure.

According to a variant of the invention, the acoustic cavities can be split into sub-cavities separated from one another. The sub-cavities can be separated from one another by additional layers allowing for generating evanescent coupling from one cavity to another. Thus the sub-cavities favor energy confinement in the structure and can lead to an improvement of the compactness of the device.

According to a variant of the invention, the cavity filter structure comprises at least three or more transducer structures in the direction of propagation of the acoustic wave. The source density can be increased, yielding an improved rejection. Also the filter band can be flatter than for the same filter with only two transducers.

According to a variant of the invention, the characteristics of the piezoelectric layer and of the electrodes of the transducer structures can be chosen such that the electromechanical coupling coefficient *kₛ²* of the shear wave, preferentially guided or guided longitudinal wave in the piezoelectric layer is superior to 5%, in particular superior to 7% to obtain a higher filter bandpass properties, in particular by adapting the electrode geometry of transducer structure, e.g. the thickness, width and/or length and/or number and/or shape of the electrodes but also the thickness of the piezoelectric layer which should be larger than or equal to 5% of the wavelength *λ*.

According to a variant of the invention, the thickness of the piezoelectric layer can be chosen such that the electromechanical coupling coefficient kₛ² of the shear wave, preferentially guided, or of the guided longitudinal wave, in the piezoelectric layer (104) is superior to 5%, in particular superior to 7%.

For a larger thickness, larger than λ, the acoustic wave loses its guided property yielding multiple wave emission in the layer and energy losses in the substrate.

According to a variant of the invention, the cavity filter structure can further comprise a dielectric layer, in particular a SiO₂ layer, sandwiched between the base substrate and the piezoelectric layer. The dielectric or passivation layer can improve the attachment of the piezoelectric layer over the base substrate but can also improve the electromechanical coupling while keeping temperature stability of the surface acoustic wave device. Preferably, the dielectric layer has a thickness of less than 1µm, in particular a thickness in a range of 100nm to 1µm.

According to a variant of the invention, the piezoelectric layer of the composite substrate can be Aluminium Nitride (NiAl), Zinc Oxide (ZnO), PZT, Niobate KNbO₃ and similar materials such as KTN, etc., as well as piezolectric relaxors such as PMN-PT and related materials, Gallium Nitride (GaN), Lithium Tantalate LiTaO₃ or Lithium Niobate LiNbO₃ with a crystallographic orientation for Lithium Tantalate LiTaO₃ or Lithium Niobate LiNbO₃ defined as (YX*I*)/θ according to the standard IEEE 1949 Std-176, with *θ*, an angle of the crystallographic orientation being comprised between 0° and 60° or between 90° and 150°.

According to a variant of the invention, the base substrate of the composite substrate can be one of Silicon, in particular a high resistivity Silicon substrate comprising a trap-rich layer, Carbon-Diamond, Sapphire, or Silicon-Carbide. By high resisitivity, one understands electrical resistivity of more than 1000 Ohmcm. For transferring piezoelectric layers on Silicon, mass production methods like SmartCut^{™}, using ion implantation in a piezoelectric source substrate to define a layer to be transferred, attaching the source substrate to a Silicon substrate and transferring the layer by a thermal or mechanical treatment, can be used. Simpler approaches based on bonding a piezoelectric substrate to the base substrate with subsequent thinning (via CMP, griniding, polishing) of the piezoelectric substrate may also be used for the present invention, in particular suitable for thick piezoelectric layers envisaged of the order of a final thickness of 5 to 20 µm. Both approaches, layer transfer via SmartCutTM or via bonding/thinning, lead to monocristalline piezoelectric layers formed on the base substrate, having thus high quality.

According to a variant of the invention, the base substrate can comprise a Bragg mirror, underneath the piezoelectric layer. The Bragg mirror consists of a stack of layers with periodically alternated acoustic impedance deposited or manufactured on top of a plate of any inorganic material. The said stack of layers behaves like a mirror for the waves excited in the top piezoelectric layer provided the thickness of each layer is about a quarter of the acoustic wavelength. Therefore, the mirror reflects waves with components pointing toward the substrate depth, confining the waves in the piezoelectric layer.

According to a variant of the invention, the coupled cavity surface acoustic wave filter structure has a filter band-pass comprised between 0,5% and 10%. It is possible to vary the bandpass of the filter device by varying the parameters of the cavity filter structure and thus the device can be adapted to the specifications of a user to obtain the required filter bandpass.

According to a variant of the invention, the coupled cavity filter structure can further comprise a passivation layer formed over the transducer structures and the at least one reflecting structures, the passivation layer having a predetermined thickness which is same or different over the transducer structures and/or the at least one reflecting structures.

The invention may be understood by reference to the following description taken in conjunction with the accompanying figures, in which reference numerals identify features of the invention.
Figure 1 illustrates a coupled cavity surface acoustic wave filter structure according to a first embodiment of the invention.
Figures 2a to 2e illustrate a coupled cavity surface acoustic wave filter structure according a second embodiment of the invention and its variants.
Figures 3a to 3d show the performance of a coupled cavity surface acoustic wave filter structure as shown in fig. 2b, with a composite substrate according to the invention, with a SiO₂ layer of 500nm in between a LiTaO₃ (YXI)/42° piezoelectric layer of 6µm and a semi-infinite (100) Silicon substrate.
Figure 4 shows a table listing the characteristics of the coupled cavity surface acoustic wave filter structure as shown in fig. 2b, according to the invention.

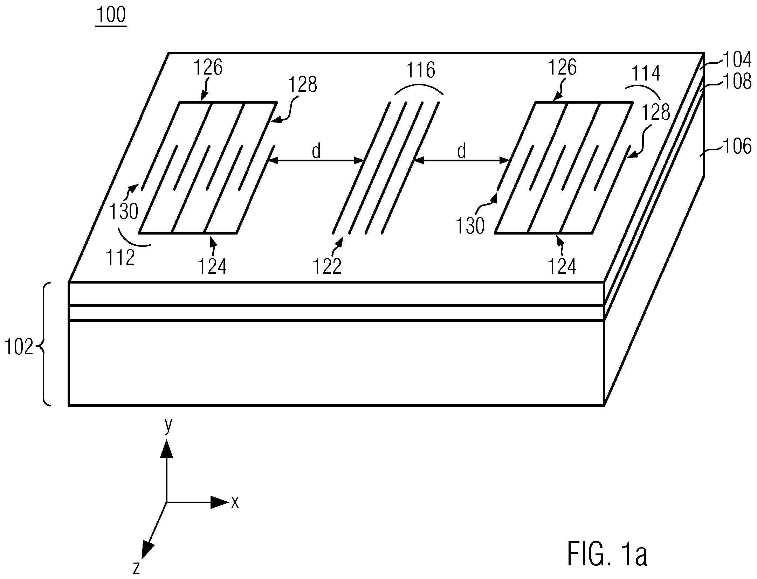

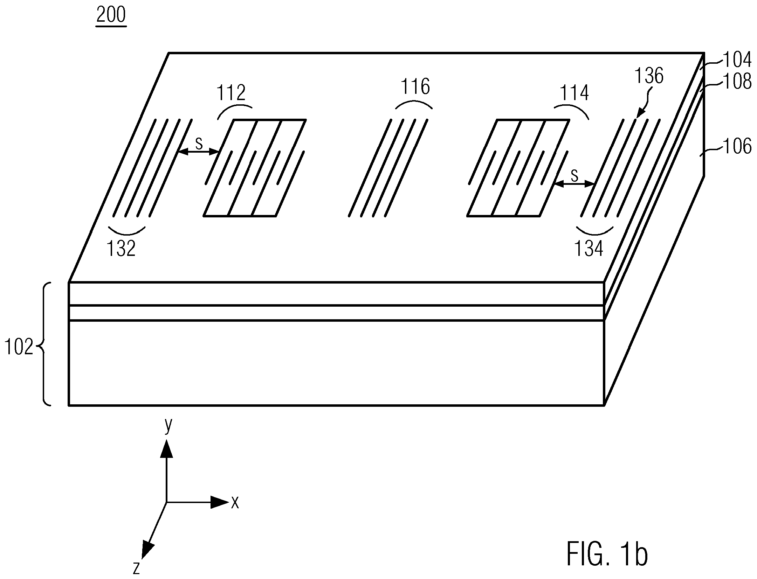

Figure 1 shows a coupled cavity surface acoustic wave filter structure according to a first embodiment of the invention. In fig. 1a, the coupled cavity surface acoustic wave filter structure 100 is realized on a substrate 102, being a composite substrate. The composite substrate 102 comprises a layer of piezoelectric material 104, with crystallographic axis X, Y and Z, formed over a base substrate 106.

The piezoelectric layer 104 in this embodiment is LiTaO₃ or LiNbO₃, particularly with cut orientations defined by (YX*I*)/θ according to the standard IEEE 1949 Std-176, with *θ*, an angle of the crystallographic orientation being comprised between 0° and 60° or between 90° and 150°, Potassium Niobate KNbO₃ and similar material composition such as KTN, as well as other piezoelectric layers using sputtered or epitaxial films, for instance Aluminium Nitride AIN, Zinc Oxide ZnO, PZT, GaN or any composition of AIN and GaN.

The thickness of the piezoelectric layer 104 formed on the base substrate 106 is of the order of one wavelength *λ* or smaller, in particular is of about 20 µm or less. The thickness t of the base substrate 106 is larger than the thickness of the piezoelectric layer 104. A preferred situation corresponds to a base substrate thickness that is at least ten times larger than the thickness of the piezoelectric layer 104, in particular 50 to 100 times larger, which would correspond to a base substrate thickness equal to 250 - 500µm.

The base substrate 106 used in the first embodiment of the invention is a Silicon substrate, in particular a high resistivity Silicon substrate. The orientation of the Silicon substrate is preferably (100) due to the higher acoustic wave propagation velocity compared to other crystalline orientation, such as for example (110), (111) or (001), which can however be used. Instead of Silicon, other substrate materials with an acoustic wave propagation velocity larger than the one of the piezoelectric layer can be chosen, such as Carbon-Diamond, Sapphire, or Silicon Carbide can be used.

In a variant of the invention, the base substrate 106 may further comprise a so called trap-rich layer close to the top layer of piezoelectric material, said trap-rich layer improving the isolation performance of the base substrate and may be formed by at least one of polycrystalline, amorphous, or porous materials such as for instance polycrystalline Silicon, amorphous Silicon, or porous Silicon, but the invention is not limited to such materials.

In a variant of the invention, the base substrate 106 can further comprise a Bragg mirror, underneath the piezoelectric layer 104. The Bragg mirror consists of a stack of layers with periodically alternated acoustic impedance deposited or manufactured on top of a plate of any inorganic material. The acoustic impedance is the product of the wave velocity times the material density and is expressed in Rayleigh and preferably in Mrayleigh, i.e. 10⁶ Rayleigh. A piezoelectric layer is deposited or manufactured atop the layer stack for the excitation and detection of acoustic waves. The stack may be advantageously composed of an alternation of Tungsten and Silica, or Si₃N₄ and SiO₂, or Mo and Al, and in general any couple of material exhibiting an acoustic impedance ratio larger than two. The inorganic sub plate may be advantageously standard silicon or high resistivity silicon or glass and generally any material exhibiting a thermal coefficient of expansion (TCE) smaller than 6ppm/K. It can also incorporate a trap-rich layer to improve electrical isolation. Advantageously, the first layer of the stack can be SiO₂ or in general any material that can be used to bound the piezoelectric layer to the above-described composite substrate.

In this embodiment, a thin SiO₂ layer 108 is provided at the interface 110 between the piezoelectric layer 104 and the base substrate 106 to improve the attachment of the piezoelectric material layer 104 to the base substrate 106. The SiO₂ layer 110 is 200nm thick, but in a variant, the thickness of the SiO₂ layer 110 can vary and be more or less than 200nm thick, in particular can vary between 10nm and 6µm.

The coupled cavity filter structure 100 comprises also two transducer structures 112, 114 and one reflecting structure 116, positioned between the two transducer structures 112, 114 at a certain distance d of the transducer structures 112, 114 in the direction of propagation X as shown in fig. 1. The region located between the reflecting structure 116 and one transducer structure 112, 114, for example the region 118 with its width defined by the distance d, corresponds to an acoustic cavity 120. Thus, in the coupled cavity surface acoustic wave filter structure 100, various acoustic cavities are present in the direction of propagation of the acoustic wave, In the coupled cavity filter structure shown in fig. 1a, two acoustic cavities 120 are present.

The reflecting structure 116 usually comprises one or more metallic strips 122, and is defined by the pitch (not shown) of the metallic strips 122, corresponding to the distance between the metallic strips 122 within the reflecting structure 116.

The transducer structure 112 and 114 correspond to an input transducer structure 112 and an output transducer structure 114, but their position can also be exchanged so that the input transducer structure is on the right side and the output transducer structure is on the left side of the structure, in the direction of propagation of the acoustic wave. The E sign represents the input acoustic signal while the S sign represents the output acoustic signal of the transducer structures.

Each transducer structure 112, 114 comprises two inter-digitated comb electrodes 124, 126, each comprising a plurality of electrode means 128, 130 respectively. In this embodiment, the electrode means 128, 130 have the shape of electrode fingers. The comb electrodes 124, 126 and its respective electrode fingers 128, 130 are formed of Aluminium-based material, for example pure Aluminium or Aluminium alloy such Al doped with Cu, Si or Ti. Nevertheless, other material may be used which generates stronger reflection coefficient for smaller electrode relative thickness. In that matter, the preferred electrode materials are Copper (Cu), Molybdenum (Mo), Nickel (Ni), Platinum (Pt) or Gold (Au) with an adhesion layer such as Titanium (Ti) or Tantalum (Ta) or Chromium (Cr), Zirconium (Zr), Palladium (Pd), Iridium (Ir), Tungsten (W), etc.

The transducer structures 112, 114 are also defined by the electrode pitch p (not shown), corresponding to the edge-to-edge electrode finger distance between two neighbouring electrode fingers 128, 130 from opposite comb electrodes 124 and 126. In a variant of the invention, the electrode pitch p is defined by the Bragg condition given by p = *λ*/2, *λ* being the operating acoustic wavelength of said transducer structures 112, 114. By operating acoustic wavelength *λ*, one understands *λ* being the acoustic wavelength following *λ* = V/f with f the predetermined central frequency of the filter structure and V the phase velocity of the utilized mode. Such transducer structure is also said to be a 2-finger-per-wavelength inter-digitated transducer (IDT).

In a variant of the invention, the inter-digitated transducer can operate out of the Bragg conditions, for instance, using a 3 or 4-finger-per-wavelength excitation structure or 5 -finger-per-two-wavelength transducers or 7 or 8 finger-per-three wavelength.

The transducer structures 112 and 114 can be symmetrical, namely they have the same number of electrode fingers 128, 130 with the same characteristics. However, in a variant of the invention, they can also be different, in particular they can have a different number of electrode fingers 128, 130.

The electrode fingers 132, 134 of the comb electrodes 128, 130 all have essentially the same length *I*, width *w* as well as thickness h. According to a variant of the embodiment, the electrode fingers 132, 134 can have different length /, width wand thickness h. The dimensions are adapted to obtain a desired coupling coefficient *kₛ*, or to take advantage of other features such as elimination of transverse modes, modulation of the IDT impedance, reduction of unwanted mode emission, etc.

In a variant of the invention, the transducer structures 112, 114 may be chirped, which means that the electrode pitch p in the transducer structure may be changed continuously in a linear way or in an hyperbolic way. This will enable to enlarge the operation frequency band of the transducer and may yield some robustness versus temperature.

The pitch of the metallic strips 122 of the reflecting structure 116 can be the same as the electrode pitch p of the transducer structure 112, 114. In a variant, the pitch of the metallic strips 122 of the reflecting structure 116 can be different to the electrode pitch p of the transducer structure 112, 114.

In a variant of the invention, the reflecting structure 116 can be chirped as well to increase the operating band of the filter and the efficiency of the resonance of the acoustic cavities 118 located in between the transducer structures 112, 114.

In a variant, the coupled cavity filter structure 100 further comprises two Bragg mirrors 132, 134. This variant is shown in figure 1b, where each Bragg mirror 132, 134 is positioned next to a transducer structure 112, 114, on the outside of the coupled cavity filter structure 200, meaning on the other side where the reflecting structure 116 is located, in the direction of propagation of the acoustic wave. Each Bragg mirror 132, 134 is positioned at a distance s of its respective transducer structure 112, 114. Each Bragg mirror 132, 134 comprises one or more metallic strips 136 and is defined by the pitch (not shown) of the metallic strips 136, corresponding to the distance between the metallic strips 136 within the Bragg mirror 132, 134.

In a variant of the invention, the reflecting structure 116 and the Bragg mirrors 132, 134 can be built by etching grooves instead of depositing metallic strips 136, 210. The grooves may be etched in the piezoelectric layer 104 of the composite substrate 102 and even down to the base substrate 106.

In a variant, a passivation layer (not shown) can be formed over the transducer structures 112, 114 and the at least one reflecting structure 116. The passivation layer has a predetermined thickness which is the same or different over the transducer structures 112, 114 and/or the at least one reflecting structures 116. The passivation layer can also be formed over the Bragg mirrors 132, 134. In this variant, the substrate may be a monolithic piezoelectric wafer such as Lithium Tantalate or Lithium Niobate bulk wafers and the passivation layer could be advantgeously a Silica SiO₂ layer or a Tantalum Pentoxide Ta₂O₅ layer. In this embodiment, the passivation layer has a positive thermal coefficient of expansion (TCE) whereas the substrate has a negative thermal coefficient of expansion (TCE), the layer thickness being set to reduce the temperature coefficient of frequency (TCF) of the SAW device.

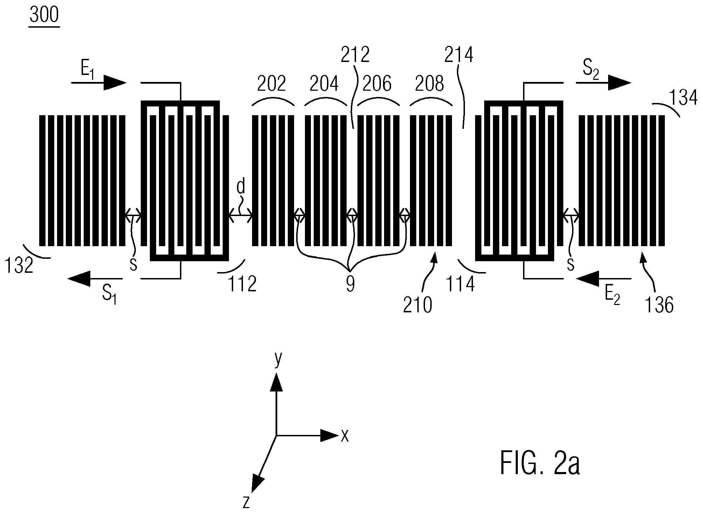

Figures 2a to 2e show the coupled cavity filter structure according to a second embodiment of the invention and its variants. For all the figures 2a to 2e, the coupled cavity filter structure is shown in a 2D plan view and the substrate on which it is positioned is not shown anymore. However, the substrate is the same as the substrate 102 of fig. 1a, 1b. The same reference numbers as in fig. 1a and 1b will be used to refer to the same features and will not be explained again in details.

In fig. 2a, the coupled cavity filter structure 300 comprises like the coupled cavity filter structure 200, two transducer structures 112, 114 with two Bragg mirrors 132, 134 each positioned next to one transducer structure. The difference with the coupled cavity filter 200 is that a plurality of reflecting structures , namely four reflecting structures 202, 204, 206, 208, are present in between the transducer structures 112, 114. Each reflecting structure 202, 204, 206, 208 of the plurality of reflecting structure comprises at least one or more metallic strips 210 and are defined by the pitch (not shown) of the metallic strips 210, corresponding to the distance between the metallic strips 210 within each reflecting structure 202, 204, 206, 208. Here, the metallic strips 210 of each reflecting structure 204, 206, 208, 210 amount to four, but it can be more or less. The reflecting structures 204, 206, 208, 210 of the plurality of reflecting structures can also have the same number of metallic strips 210 but in a variant, they can each have different number of metallic strips 210. For example, the number of metallic strips 210 in the reflecting structures 204, 206, 208, 210 can increase then decrease throughout the whole reflecting structures 204, 206, 208, 210 in between the transducer structures 112, 114 to reinforce the resonance at the actual center of the structure.

These reflecting structures 202, 204, 206, 208 are separated from each other by a gap g. The region located in between two adjacent reflecting structures, for example 202 and 204 with its width defined by the gap g, corresponds to an acoustic cavity 212. Like for the coupled cavity filter structure 100 and 200, the region located between a reflecting structure and an adjacent transducer structure corresponds also to an acoustic cavity 214, but with a width defined by the distance d between the reflective structure and the adjacent transducer structure. Thus, in the coupled cavity surface acoustic wave filter structure, various cavities are present in the direction of propagation of the acoustic wave, being separated by a reflecting structure, or said otherwise, a cavity is surrounded by two reflecting structures in between the transducer Thus, in the coupled cavity filter structure 300 shown in fig. 2a, a total of five acoustic cavities 212, 214 are present, in the direction of propagation of the mode. For a given number of reflecting structures in between the transducer structures, and with the transducer structures operating at the Bragg condition, the number of acoustic cavities equal the number of reflecting structure plus one.

In a variant of the invention, the reflecting structures 202, 204, 206, 208 can be chirped as well to increase the operating band of the filter and the efficiency of the resonance of the acoustic cavities 212, 214 located in between the transducer structures 212, 214.

In a variant of the invention, the reflecting structures 202, 204, 206, 208 and the Bragg mirrors 132, 134 can be built by etching grooves instead of depositing metallic strips 136, 210. The grooves may be etched in the piezoelectric layer 104 of the composite substrate 102 and even down to the base substrate 106.

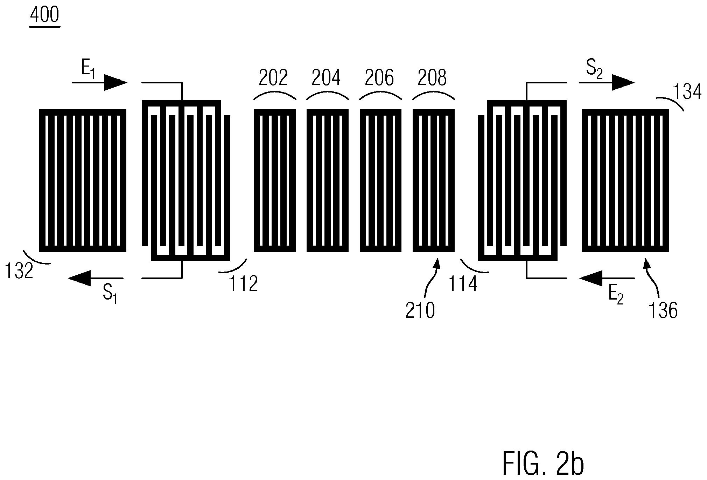

In a variant of the invention, the metallic strips 136, 210 of the reflecting structures 202, 204, 206, 208 and / or of the Bragg mirrors 132, 134 can be electrically connected to each other. The variant where the reflecting strips 136, 210 of both the reflecting structures 202, 204, 206, 208 and the Bragg mirrors 132, 134 are connected to each other is shown in fig. 2b for the coupled cavity filter structure 400. This results in an improvement of the reflection coefficient of the reflecting structures 202, 204, 206, 208 and of the Bragg mirrors 132, 134 at the Bragg condition. All the reflecting structures 202, 204, 206, 208 and / or Bragg mirrors 132, 134 are operating in the so-called short-circuit conditions, meaning that all the metallic strips 136, 210 of a given reflecting structure 202, 204, 206, 208 / Bragg mirror 132, 134 are connected to one another, yielding a constant value of the electrical potential throughout the said grating structure.

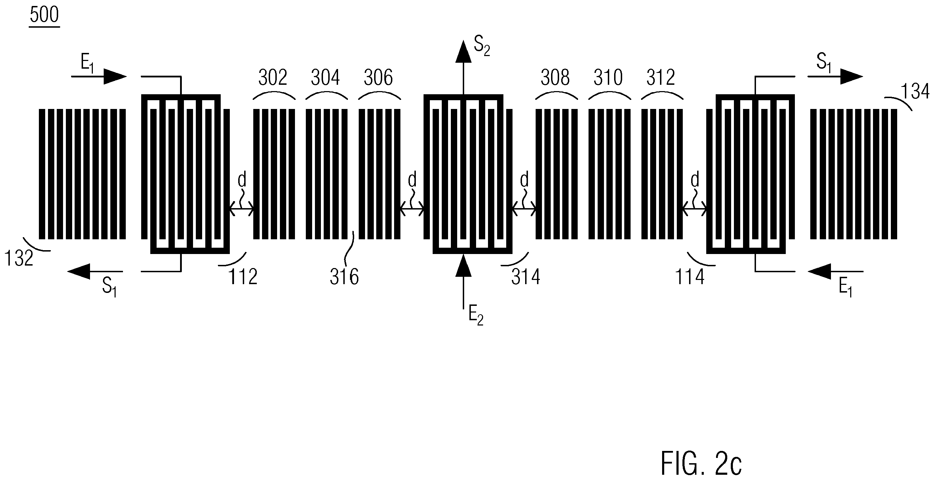

In a variant of the invention, the coupled cavity filter structure can comprise three transducer structures or even more. In fig. 2c is shown the variant where three transducers structures 402, 404, 406 are present in the coupled cavity filter structure 400. The coupled cavity filter structure 400 is also different from the coupled cavity filter structure 300 as shown in fig. 2a as the plurality of reflecting structures comprises in total six reflecting structures 302, 304, 306, 308, 310, 312. Again, the same reference numbers will be used to describe the same features already described in fig. 2a for the coupled cavity filter structure 300.

Two of the transducer structures 112, 114 are positioned, like in the structure of fig. 2a, on the outside of the reflecting structures 302, 304, 306, 308, 310, 312 while the third transducer structure 314 is positioned in the middle of the reflecting structures 302, 304, 306, 308, 310, 312116, so that on each side of the third transducer structure 314, three reflecting structures 302, 304, 306 and 308, 310, 312 are present. The transducer structure 314 is also separated from the two adjacent reflecting structure by a distance d, corresponding to the same distance between the transducer structure 112, 114 and their respective neighbouring reflecting structure, here 302 for the transducer structure 112 and 312 for the transducer structure 114. The coupled cavity filter 500 comprises then in total eight acoustic cavities 316. Such a cavity filter structure 500 is symmetrical and results in a stronger confinement of energy in the cavities 316 compare to the cavity filter structure 300 as shown in fig. 2a, with only two transducer structures 112, 114.

In a variant of the invention, the third transducer 314 is not positioned in the middle of the coupled cavity filter structure so that the coupled cavity filter structure is not symmetrical.

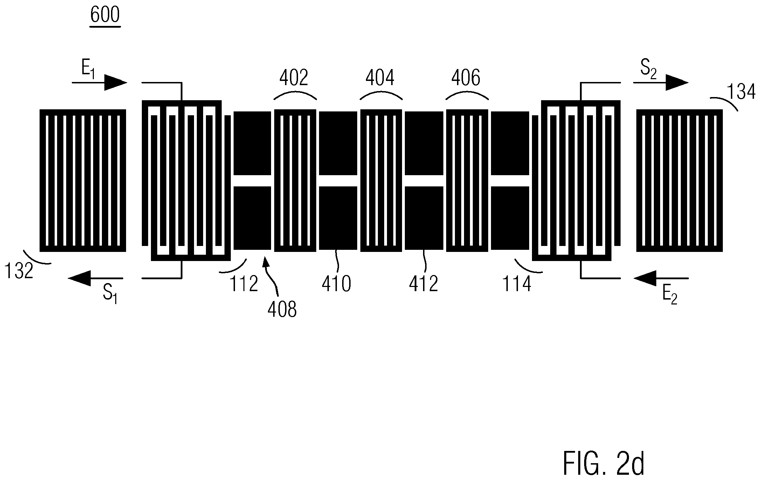

In a variant of the invention, the plurality of acoustic cavities can be split into sub-cavities. This variant is shown in fig. 2d, where the sub-cavities are separated from one another by the presence of additional layers. Again, the coupled cavity filter structure 600 is also different from the coupled cavity filter structure 300 as shown in fig. 2a as the plurality of reflecting structures comprises in total three reflecting structures 402, 404, 406. Again, the same reference numbers will be used to describe the same features already described in fig. 2a for the coupled cavity filter structure 300. In the cavity filter structure 600, the acoustic cavities 408 located in between the reflecting structures 402, 404, 406 and between a transducer structure 112, 114 and its neighbouring reflecting structure 402 and 406 respectively, are split in two sections, resulting in the presence of eight dark regions 410 and four white regions 412 between the two transducer structures 112, 114. The dark regions 410 represent locations where the wave velocity is smaller than in the white regions 412, thus leading to a better energy confinement than in the coupled cavity filter structure 300 shown in fig. 2a. Thus the coupled cavity filter structure 600 yields additional poles, leading to an improvement of the compactness of the coupled cavity filter structure 600.

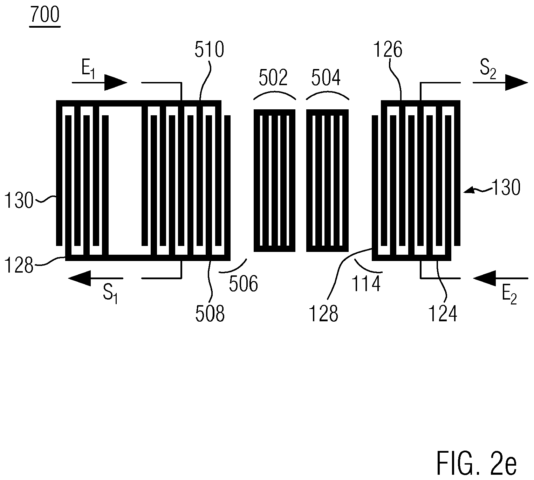

In a variant of the invention, the input and output transducer structures are not symmetrical or identical, and this variant is shown in fig. 2e. Again, the coupled cavity filter structure 700 is also different from the coupled cavity filter structure 300 as shown in fig. 2a, as the plurality of reflecting structures comprises in total two reflecting structures 502, 504. Again, the same reference numbers will be used to describe the same features already described in fig. 2a for the coupled cavity filter structure 300. In fig. 2, the number of electrode fingers of each transducer structure is different. In the coupled cavity filter structure 700, the transducer structure 114 comprises inter-digitated comb electrodes 124, 126 with each five electrode fingers 128, 130, with a constant electrode pitch p throughout the whole transducer structure 114. The transducer structure 506 comprises inter-digitated comb electrodes 508, 510, but they each have eight electrode fingers 128, 130 and furthermore a gap is present in the transducer structure 506 between the third electrode finger 128 of the comb electrode 508 and the fourth electrode finger 130 of the comb electrode 510. Furthermore, in this variant, no Bragg mirrors are present next to the transducer structures 114, 506, which will yield more losses and ripples than the coupled cavity filter structure 300 of fig. 2a. However, this coupled cavity filter structure 700 offers a more compact and simpler design than the structure shown in fig. 2a.

The coupled cavity surface acoustic wave filter structure functions in the following way. An input inter-digitated transducer (IDT) emits acoustic energy toward the reflecting structure and excites its resonance. The reflecting structure is coupled to another one which therefore generates coupling conditions yielding energy transfer from one reflecting structure to another. A plurality of such reflecting structures can be coupled to one another but there is at least one output transducer structure which collects the transmitted energy.

Thus, the invention proposes to use a coupled cavity filter structure which takes advantage of the wave guidance of the top piezoelectric layer from the composite substrate and uses acoustic resonant cavities that couple energy from one reflecting structure to another.

In case of a coupled cavity filter structure, the resonance of the transducer structure is occurring in the low frequency transition band of the filter and the anti-resonance almost in the middle of the filter band. Therefore, conditions on the electromechanical coupling coefficient are similar to those required for impedance filters, namely that the coupling coefficient must be 1.5 to twice larger than the band to be achieved, as a given mode must exhibit a coupling factor in proportion of the bandpass to be achieved, allowing for reducing the insertion loss within this band. However, large reflection coefficients larger than the coupling coefficient, ideally 1,5 times or more the coupling coefficient are required to achieve the filter band.

According to the invention, the relation of the reflection coefficient with respect to the coupling coefficient can be achieved with the composite substrate, even when the coupling coefficient of the transducer structure is 5% or more. This is particularly true, when using shear waves or longitudinally waves guided in the piezoelectric layer of the composite substrate.

Due to the thickness of the piezoelectric layer, being lower than the wavelength, a shear wave mode or a longitudinal mode is guided within the piezoelectric layer. Furthermore, the energy loss in the composite substrate can be reduced. The thickness of the piezoelectric layer should be larger than or equal to 5% of the wavelength *λ*. For thick piezoelectric layers the shear mode of a composite substrate is not entirely guided anymore but has a lossy bulk component which reflects at the interface to the base substrate and leads to parasitic modes or rattle effect. These effects typically occur when at least two modes are excited.

In this context, a thin piezoelectric layer typically corresponds to a thickness up to 50% of the wavelength *λ* and a thick piezoelectric layer to a layer of more than 50% of the wavelength λ. However, even in the presence of a bulk component, the fundamental mode can typically be exploited up to a thickness of 1.5 times *λ*.

The figure of merit of a filter device is the transmission of the filter which shows the filter bandpass as a function of the frequency with the level of losses in dB in the bandpass. The filter bandpass depends on various factors, namely the coupling coefficient, the number of cavities and the coefficient of reflection.

Depending on the dimensions of piezoelectric layer, of the transducer structures, of the length of the reflecting structures, the number of coupled reflecting structures and the coupling coefficient of the mode, it is possible to synthesize a multiple pole and zero filter with extremely low insertion losses, i.e. better than 2dB, in particular less than 1dB, with a 15 to 20dB rejection or even more according to the design and the selectivity of the transducer structures.

Concerning the dimension of the acoustic cavities, said acoustic cavities should ideally be a quarter wavelength long or an odd number of quarter wavelength to meet the optimal resonance conditions according to the state of the art. In the present invention, the acoustic cavities length can be inferior to a quarter wavelength. This is due to the strong velocity change from free surface to grating area, yielding an acoustic impedance mismatch much larger than accessible using standard true SAW solutions

Concerning the coupling coefficient, for a composite substrate and for the metallic strips parameters (material, dimensions), the coupling coefficient is directly related to the bandpass value by a factor 0.7, so that the required bandpass of the filter device can be obtained by choosing the materials and the dimensions of the cavity filter structure.

Concerning the number of metallic strips in the reflecting structures, it is chosen to generate a global reflection coefficient larger than 0.5, in particular larger than 0.8, to allow confinement of the acoustic energy in the cavity and therefore to provide mode coupling conditions.

As already mentioned, the magnitude of the reflection coefficient preferably is larger than the coupling coefficient, ideally 1.5 times higher or more than the coupling coefficient parameter.

The larger the reflection coefficient, the smaller the number of metallic strips and therefore the larger the filter bandwidth will be. For instance, a reflection coefficient larger than 15% allows for reducing the number of metallic strips composing the reflecting structures, which directly impacts the bandwidth of the filter: the smaller the number of metallic strips in the reflecting structures, the larger the bandwidth, provided the reflection coefficient of the structure is large or equal 50%. Considering a reflection coefficient larger than 15%, a filter with bandwidth larger than 5% can be achieved.

A particular example of a filter device operating at 2.6GHz with a bandwidth in excess of 7% and in-band ripples smaller than 0.6dB is given with a 30nm thick Tantalum (Ta) electrodes on a composite substrate comprising a 300nm thick (YX/)/52° LiNbO₃ layer on a 1µm thick SiO₂ layer onto (100) Silicon substrate. In this example, the reflection coefficient reaches 20% and the coupling factor about 18%.

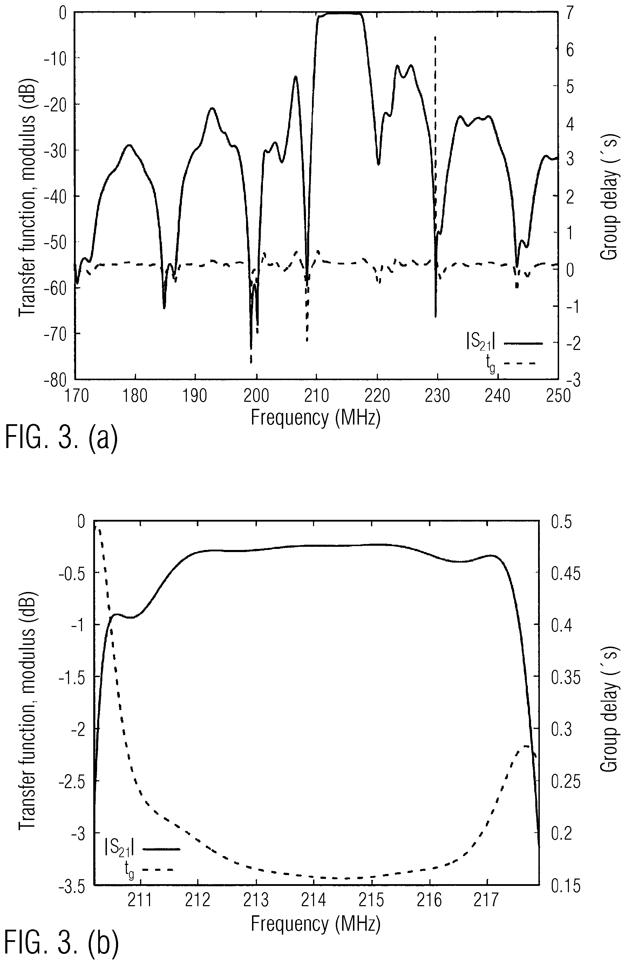

Figures 3a - 3d show the characteristics of a surface acoustic wave filter device comprising a cavity filter structure as shown in fig. 2b, with a composite substrate according to the invention, with a SiO₂ layer of 500nm in between a LiTaO₃ (YX/)/42° piezoelectric layer of 6µm and a semi-infinite (100) Silicon substrate. This configuration is suitable to operate in the frequency range 50 to 250MHz.

On such a composite substrate, a pure shear true mode can be excited and propagates.

For this SAW filter device, the coupled cavity filter structure shown in fig. 2b was used, namely an input and an output transducer structures with each an adjacent Bragg mirror, four reflecting structures leading to five acoustic cavities present in between the transducer structures.

The metallic strips of both each reflecting structures and the Bragg mirrors are connected to each other for a short-circuit operation.

The inter-digitated transducer structure have an electrode pitch set to 9.95 µm and a ratio a/p set to 0.3, with a number of electrode finger pair set to 15. Furthermore, the mirror grating period is set to 10µm and a/p to 0.4, with 30 electrodes. The gap between the mirror grating and the inter-digitated transducer structure is set to 9µm, corresponding to about half a wavelength. Two internal reflecting structures of 14 electrodes each are separated by a gap g of 4.8µm, corresponding to about a quarter wavelength. The aperture is then 3.1mm.

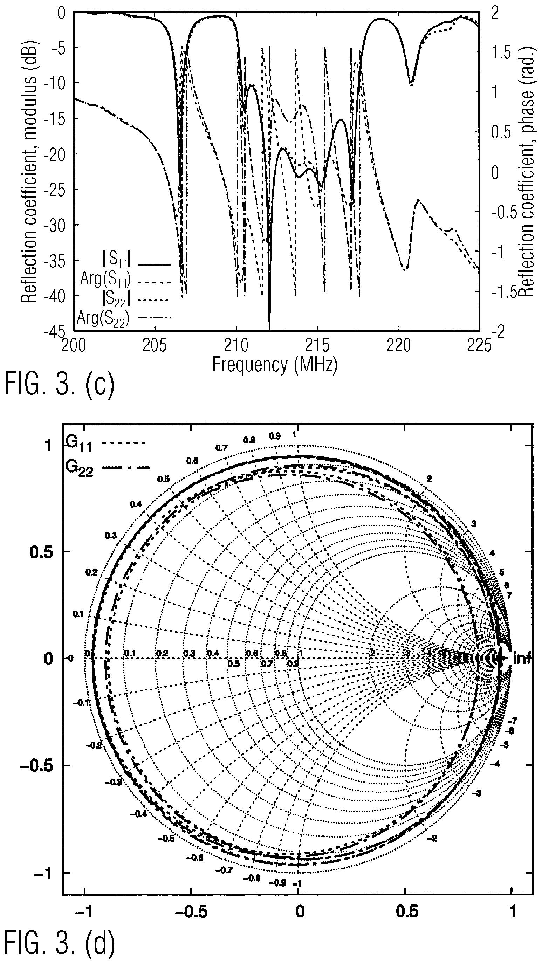

Figure 3a shows a general view of the filter transfer function and the group delay of the filter as a function of frequency (MHz), from 170 to 250MHz. The group delay is a measure of the phase linearity. Figure 3b shows a zoom of fig. 3a near the central frequency and thus focuses on the bandpass, showing the very low losses of the transfer. Figure 3c is the reflection coefficient, showing the signature of the pole of the filter (minimum |S₁₁| peaks), in function of the frequency (MHz) as well. Figure 3d is a Smith abacus plot of the so-called reflection coefficient currently used by the skilled person in the art to assess electrical impedance matching of both ports of the filter. The reflection coefficient must be centered around the 50 Ohm condition, i.e. the center of the abacus to be matched.

The transfer function in fig. 3a indicates the performance of the device, with a filter bandpass between 210 and 218MHz. In fig. 3b, it can be seen that the filter bandpass shows a flat profile at around 0.5dB with low in-band ripples.

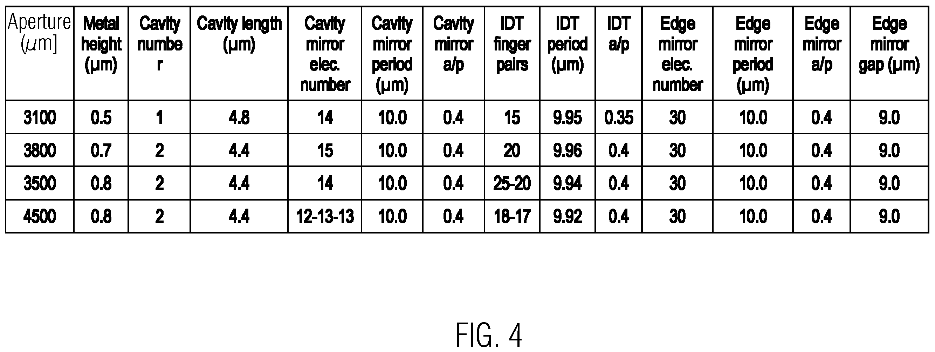

Figure 4 shows a table listing the characteristics of the coupled cavity surface acoustic wave filter structure as shown in fig. 2b, according to the invention. For all the coupled cavity filter structures, the composite substrate used was the same as for fig. 3, namely a LiTaO₃ (YX/)/42° piezoelectric layer of 6µm, with a SiO₂ layer of 500nm in between the piezoelectric layer and the semi-infinite (100) Silicon base substrate.

The coupled cavity filter structure corresponds to fig. 2b, namely an input and an output transducer structures with each an adjacent Bragg mirror, four reflecting structures leading to five acoustic cavities present in between the transducer structures. The metallic strips of both each reflecting structures and the Bragg mirrors are connected to each other for a short-circuit operation.

All the coupled cavity filter structures described in figure 4 correspond to the propagation of a pure shear wave mode and show performance, i.e. a filter band-pass varying from 0,5 to 10%, low insertion loss of below 2dB, with a 15dB to 20dB rejection loss, a coupling factor above 5% and temperature coefficient of frequency (TCF) below 20ppm/K. Bandpass as large as 10% can be achieved using LNO thin layers with for instance Pt or W or Ta or Mo based electrodes with thickness compatible with current deposition technologies, namely with h/A equal of less than 5%, with h the absolute thickness of the metal strip).

For a required performance of the coupled cavity SAW filter device, it is thus possible to choose the materials in order to adjust the coupling coefficient and to adjust the number and size of the reflecting structures so as not to go over a size limit of the coupled cavity filter structure.

A coupled cavity SAW filter device according to the invention uses a shear wave of a composite substrate in order to obtain a narrow filter band-pass comprised between 0.5% and 10%, low insertion loss of below 2dB, with a 15dB to 20dB rejection loss as well as low ripples within the filter band-pass, with a reduced size due to an improved compactness.

A number of embodiments of the invention have been described. Nevertheless, it is understood that various modifications and enhancements may be made as long as they remain within in the scope of the following claims.

## Claims

1. Coupled cavity filter structure using a guided surface acoustic wave comprising:
an acoustic wave propagating substrate (102);
at least one input transducer structure (112, 506) and one output transducer structure (114, 506), provided over the substrate (102), each comprising inter-digitated comb electrodes (124, 126, 508, 510),
one reflecting structure (116), said reflecting structure (116) comprising at least one or more metallic strips (122), positioned in between the input and output transducer structures (112, 114, 506) at a distance d of the input and output transducer structures (112, 114, 506), in the direction of propagation of an acoustic wave, **characterised in that**
the acoustic wave propagation substrate (102) is a composite substrate comprising a base substrate (106) and a piezoelectric layer (104), wherein the thickness of the piezoelectric layer (104) is smaller or equal to 1.5 *λ*, wherein *λ* is the wavelength of the fundamental mode of the guided surface acoustic wave, and each region (118) located between said reflecting structure (116) and each of the input transducer structure (112, 114, 506) and the output transducer structure (112, 114, 506) respectively, forms an acoustic cavity (120) with its width defined by the distance d,
and the coupled cavity filter is configured so that the guided surface acoustic wave is a guided shear wave or a guided longitudinal wave inside the piezoelectric layer (104).

2. Coupled cavity filter structure according to claim 1, wherein the inter-digitated comb electrodes (124, 126) of the at least one input transducer structure (112) and one output transducer structure (114) are defined by the Bragg condition given by p = *λ*/*2, λ* being the operating acoustic wavelength of said transducer structures (112, 114) and p being the electrode pitch of said transducer structures (112, 114).

3. Coupled cavity filter structure according to one of claims 1 to 2, comprising further at least one Bragg mirror (132, 134), located apart the input and/or output transducer structure (112, 114) on the opposite side of the side where the one reflecting structure (116) is located, in the direction of propagation of the acoustic wave.

4. Coupled cavity filter structure according to one of claims 1 to 3, comprising a plurality of reflecting structures separated from each other by a gap g and positioned between the input and output transducer structures (112, 114, 506) at a distance d of the input and output transducer (112, 114, 506), in the direction of propagation of an acoustic wave, each gap g between the reflecting structures (116, 202, 204, 206, 208, 302, 304, 306, 308, 310, 312, 402, 404, 406) and each distance d between a transducer structure (112, 114) and its neighbouring reflecting structure forming an acoustic cavity (120, 212, 214, 316, 408).

5. Coupled cavity filter structure according to one of claims 1 to 4, wherein the dimension of each acoustic cavity (120, 212, 214, 316, 408) is smaller than λ/4..

6. Coupled cavity filter structure according to one of claims 1 to 5, wherein the dimension of each acoustic cavity (120, 212, 214, 316, 408) is so that the phase velocity in the acoustic cavity (120, 212, 214, 316, 408) is superior to the phase velocity within the reflecting structure (116, 202, 204, 206, 208, 302, 304, 306, 308, 310, 312, 402, 404, 406).

7. Coupled cavity filter structure according to one of claims 4 to 6, wherein the gaps g between neighbouring reflecting structures (202, 204, 206, 208, 302, 304, 306, 308, 310, 312, 402, 404, 406) of the plurality of reflecting structures and / or the distance d between a reflecting structure (116, 202, 204, 206, 208, 302, 304, 306, 308, 310, 312, 402, 404, 406) and a neighbouring transducer structure (112, 114, 506) is the same.

8. Coupled cavity filter structure according to one of claims 4 to 6, wherein the gaps g between neighbouring reflecting structures (202, 204, 206, 208, 302, 304, 306, 308, 310, 312, 402, 404, 406) of the plurality of reflecting structures and / or the distance d between a reflecting structure (116, 202, 204, 206, 208, 302, 304, 306, 308, 310, 312, 402, 404, 406) and a neighbouring transducer structure (112, 114, 506) is different.

9. Coupled cavity filter structure according to one of claims 1 to 8, wherein the reflecting structure (116) or the reflecting structures (202, 204, 206, 208, 302, 304, 306, 308, 310, 312, 402, 404, 406) has / have a reflection coefficient regarding a unitary metallic strip superior to the coupling coefficient *kₛ²* regarding the composite substrate (102) and the comb electrodes (124, 126, 604, 606) of the transducer structure (112, 114, 506).

10. Coupled cavity filter structure according to one of claims 1 to 9, wherein the input and output transducer structures (112, 114, 506) have a different number of electrode fingers (128, 130).

11. Coupled cavity filter structure according to one of claims 1 to 10, wherein each reflecting structure (116, 202, 204, 206, 208, 302, 304, 306, 308, 310, 312, 402, 404, 406) of the plurality of reflecting structures comprises metallic strips (122, 210) with a pitch of the metallic strips being the same to the electrode pitch p of the input and output transducer structures (112, 114, 506).

12. Coupled cavity filter structure according to one of claims 1 to 10, wherein each reflecting structure (116, 202, 204, 206, 208, 302, 304, 306, 308, 310, 312, 402, 404, 406) of the plurality of reflecting structures comprises metallic strips (122, 210) with a pitch of the metallic strips being different to the electrode pitch p of the input and output transducer structures (112, 114, 506).

13. Coupled cavity filter structure according to one of claims 1to 12, wherein the metallic strips (124) of each reflecting structure (116, 202, 204, 206, 208, 302, 304, 306, 308, 310, 312, 402, 404, 406) of the plurality of reflecting structures are electrically connected to each other.

14. Coupled cavity filter structure according to one of claims 1 to 13, wherein the number of metallic strips (122, 210) of each reflecting structure (116, 202, 204, 206, 208, 302, 304, 306, 308, 310, 312, 402, 404, 406) of the plurality of reflecting structures is below 30, so that the reflection coefficient of the plurality of reflecting structures is above 0.5.

15. Coupled cavity filter structure according to one of claims 1 to 14, wherein the difference between the acoustic impedance of the material from the piezoelectric layer (104) and the material from the metallic strips (122, 210) of the plurality of reflecting structure is such that the reflection coefficient of the plurality of reflecting structures is superior to 0.5.

16. Coupled cavity filter structure according to one of claims 1 to 15, wherein the acoustic cavities (120, 212, 214, 316, 408) are split into sub-cavities (410) separated from one another.

17. Coupled cavity filter structure according to one of claims 1 to 16, comprising at least three or more transducer structures (112, 114, 314, 506) in the direction of propagation of the acoustic wave.

18. Coupled cavity filter structure according to one of claims 1 to 17, wherein the characteristics of the piezoelectric layer (104) and of the electrodes (124, 126, 508, 510) of the transducer structures (112, 114, 314, 506) are chosen such that the electromechanical coupling coefficient *kₛ²* of the guided shear wave, or of the guided longitudinal wave, in the piezoelectric layer (104) is superior to 5%.

19. Coupled cavity filter structure according to one of claims 1 to 18, wherein the thickness of the piezoelectric layer (104) is chosen such that the electromechanical coupling coefficient *kₛ²* of the guided shear wave, or of the guided longitudinal wave, in the piezoelectric layer (104) is superior to 5%.

20. Coupled cavity filter structure according to one of claims 1 to 19, further comprising a dielectric layer (108), sandwiched between the base substrate (106) and the piezoelectric layer (104).

21. Coupled cavity filter structure according to one of claims 1 to 20, wherein the piezoelectric layer (104) is Aluminium Nitride (AIN), Zinc Oxide (ZnO), PZT, Gallium Nitride (GaN), Lithium Tantalate LiTaO₃ or Lithium Niobate LiNbO₃ with a crystallographic orientation for Lithium Tantalate LiTaO₃ or Lithium Niobate LiNbO₃ defined as (YX*I*)/θ according to the standard IEEE 1949 Std-176, with *θ*, an angle of the crystallographic orientation being comprised between 0° and 60° or between 90° and 150°.

22. Coupled cavity filter structure according to one of claims 1 to 21, wherein the base substrate (106) of the composite substrate (102) is one of Silicon, Carbon-Diamond, Sapphire, Quartz, or Silicon-Carbide.

23. Coupled cavity filter structure according to one of claims 1 to 22, wherein the base substrate (106) comprises a Bragg mirror underneath the piezoelectric layer (104).

24. Coupled cavity filter structure according to one of claims 1 to 23, wherein the filter bandpass is comprised between 0.5% and 10%.

25. Coupled cavity filter structure according to one of claims 1 to 24 further comprising a passivation layer formed over the transducer structures (112, 114, 314, 506) and the at least one reflecting structures, the passivation layer having a predetermined thickness which is same or different over the transducer structures (112, 114, 314, 506) and/or the at least one reflecting structures.

## Patentansprüche

1. Gekoppelte Hohlraumfilter-Struktur, bei der eine geführte akustische Oberflächenwelle zum Einsatz kommt, wobei sie umfasst:
ein Substrat (102) für Ausbreitung akustischer Wellen;
wenigstens eine Eingangswandler-Struktur (112, 506) und eine Ausgangswandler-Struktur (114, 506), die über dem Substrat (102) vorhanden sind und jeweils ineinandergreifende Kammelektroden (124, 126, 508, 510) umfassen,
eine reflektierende Struktur (116), wobei die reflektierende Struktur (116) wenigstens einen oder mehrere Metallstreifen (122) umfasst, der/die zwischen der Eingangs- und der Ausgangswandler-Struktur (112, 114, 506) in einem Abstand d zu der Eingangs- und der Ausgangswandler-Struktur (112, 114, 506) in der Ausbreitungsrichtung einer akustischen Welle positioniert ist/sind, **dadurch gekennzeichnet, dass**
das Substrat (102) für Ausbreitung akustischer Wellen ein Verbundsubstrat ist, das ein Basissubstrat (106) sowie eine piezoelektrische Schicht (104) umfasst, wobei die Dicke der piezoelektrischen Schicht (104) weniger als oder 1,5 *λ* beträgt, wobei *λ* die Wellenlänge der Grundmode der geführten akustischen Oberflächenwelle ist, und jeder Bereich (118), der sich jeweils zwischen der reflektierenden Struktur (116) und der Eingangswandler-Struktur (112, 114, 506) bzw. der Ausgangswandler-Struktur (112, 114, 506) befindet, einen akustischen Hohlraum (120) bildet, dessen Breite durch den Abstand d definiert ist,
und der gekoppelte Hohlraumfilter so ausgeführt ist, dass die geführte akustische Oberflächenwelle eine geführte Scherwelle oder eine geführte Longitudinalwelle innerhalb der piezoelektrischen Schicht (104) ist.

2. Gekoppelte Hohlraumfilter-Struktur nach Anspruch 1, wobei die ineinandergreifenden Kammelektroden (124, 126) der wenigstens einen Eingangswandler-Struktur (112) und einen Ausgangswandler-Struktur (114) durch die Bragg-Bedingung definiert sind, die durch *p* = *λ*/*2* gegeben ist, wobei *λ* die akustische Arbeitswellenlänge der Wandler-Strukturen (112, 114) ist und p der Elektrodenabstand der Wandler-Strukturen (112, 114) ist.

3. Gekoppelte Hohlraumfilter-Struktur nach einem der Ansprüche 1 bis 2, die des Weiteren wenigstens einen Bragg-Spiegel (132, 134) umfasst, der getrennt von der Eingangs-und/oder der Ausgangswandler-Struktur (112, 114) an der Seite in der Ausbreitungsrichtung der akustischen Welle angeordnet ist, die der Seite gegenüberliegt, an der sich die eine reflektierende Struktur (116) befindet.

4. Gekoppelte Hohlraumfilter-Struktur nach einem der Ansprüche 1 bis 3, die eine Vielzahl reflektierender Strukturen, die durch einen Spalt g voneinander getrennt und in der Ausbreitungsrichtung einer akustischen Welle zwischen der Eingangs- und der Ausgangswandler-Struktur (112, 114, 506) in einem Abstand d zu dem Eingangs- und dem Ausgangswandler (112, 114, 506) positioniert sind, wobei jeder Spalt g zwischen den reflektierenden Strukturen (116, 202, 204, 206, 208, 302, 304, 306, 308, 310, 312, 402, 404, 406) und jeder Abstand d zwischen einer Wandler-Struktur (112, 114) und ihrer benachbarten reflektierenden Struktur einen akustischen Hohlraum (120, 212, 214, 316, 408) bilden.

5. Gekoppelte Hohlraumfilter-Struktur nach einem der Ansprüche 1 bis 4, wobei die Abmessung jedes akustischen Hohlraums (120, 212, 214, 316, 408) kleiner ist als λ/4.

6. Gekoppelte Hohlraumfilter-Struktur nach einem der Ansprüche 1 bis 5, wobei die Abmessung jedes akustischen Hohlraums (120, 212, 214, 316, 408) so ist, dass die Phasengeschwindigkeit in dem akustischen Hohlraum (120, 212, 214, 316, 408) höher ist als die Phasengeschwindigkeit innerhalb der reflektierenden Struktur (116, 202, 204, 206, 208, 302, 304, 306, 308, 310, 312, 402, 404, 406).

7. Gekoppelte Hohlraumfilter-Struktur nach einem der Ansprüche 4 bis 6, wobei die Spalte g zwischen benachbarten reflektierenden Strukturen (202, 204, 206, 208, 302, 304, 306, 308, 310, 312, 402, 404, 406) der Vielzahl reflektierender Strukturen und/oder der Abstand d zwischen einer reflektierenden Struktur (116, 202, 204, 206, 208, 302, 304, 306, 308, 310, 312, 402, 404, 406) und einer benachbarten Wandler-Struktur (112, 114, 506) gleich sind.

8. Gekoppelte Hohlraumfilter-Struktur nach einem der Ansprüche 4 bis 6, wobei die Spalte g zwischen benachbarten reflektierenden Strukturen (202, 204, 206, 208, 302, 304, 306, 308, 310, 312, 402, 404, 406) der Vielzahl reflektierender Strukturen und/oder der Abstand d zwischen einer reflektierenden Struktur (116, 202, 204, 206, 208, 302, 304, 306, 308, 310, 312, 402, 404, 406) und einer benachbarten Wandler-Struktur (112, 114, 506) verschieden sind.

9. Gekoppelte Hohlraumfilter-Struktur nach einem der Ansprüche 1 bis 8, wobei die reflektierende Struktur (116) oder die reflektierenden Strukturen (202, 204, 206, 208, 302, 304, 306, 308, 310, 312, 402, 404, 406) einen Reflexionskoeffizienten bezüglich eines einheitlichen Metallstreifens aufweist/aufweisen, der höher ist als der Kopplungskoeffizient *kₛ²* bezüglich des Verbundsubstrats (102) und der Kammelektroden (124, 126, 604, 606) der Wandler-Struktur (112, 114, 506).

10. Gekoppelte Hohlraumfilter-Struktur nach einem der Ansprüche 1 bis 9, wobei die Eingangs- und die Ausgangswandler-Struktur (112, 114, 506) eine unterschiedliche Anzahl von Elektrodenfingern (128, 130) aufweisen.

11. Gekoppelte Hohlraumfilter-Struktur nach einem der Ansprüche 1 bis 10, wobei jede reflektierende Struktur (116, 202, 204, 206, 208, 302, 304, 306, 308, 310, 312, 402, 404, 406) der Vielzahl reflektierender Strukturen Metallstreifen (122, 210) umfasst und ein Abstand der Metallstreifen der gleiche ist wie der Elektrodenabstand p der Eingangs- und der Ausgangswandler-Struktur (112, 114, 506).

12. Gekoppelte Hohlraumfilter-Struktur nach einem der Ansprüche 1 bis 10, wobei jede reflektierende Struktur (116, 202, 204, 206, 208, 302, 304, 306, 308, 310, 312, 402, 404, 406) der Vielzahl reflektierender Strukturen Metallstreifen (122, 210) umfasst und ein Abstand der Metallstreifen sich von dem Elektrodenabstand p der Eingangs- und der Ausgangswandler-Struktur (112, 114, 506) unterscheidet.

13. Gekoppelte Hohlraumfilter-Struktur nach einem der Ansprüche 1 bis 12, wobei die Metallstreifen (124) jeder reflektierenden Struktur (116, 202, 204, 206, 208, 302, 304, 306, 308, 310, 312, 402, 404, 406) der Vielzahl reflektierender Strukturen elektrisch miteinander verbunden sind.

14. Gekoppelte Hohlraumfilter-Struktur nach einem der Ansprüche 1 bis 13, wobei die Anzahl von Metallstreifen (122, 210) jeder reflektierenden Struktur (116, 202, 204, 206, 208, 302, 304, 306, 308, 310, 312, 402, 404, 406) der Vielzahl reflektierender Strukturen unter 30 liegt, so dass der Reflexionskoeffizient der Vielzahl reflektierender Strukturen über 0,5 liegt.

15. Gekoppelte Hohlraumfilter-Struktur nach einem der Ansprüche 1 bis 14, wobei die Differenz zwischen der akustischen Impedanz des Materials der piezoelektrischen Schicht (104) und des Materials der Metallstreifen (122, 210) der Vielzahl reflektierender Strukturen so ist, dass der Reflexionskoeffizient der Vielzahl reflektierender Strukturen über 0,5 liegt.

16. Gekoppelte Hohlraumfilter-Struktur nach einem der Ansprüche 1 bis 15, wobei die akustischen Hohlräume (120, 212, 214, 316, 408) in voneinander getrennte Teilhohlräume (410) aufgeteilt sind.

17. Gekoppelte Hohlraumfilter-Struktur nach einem der Ansprüche 1 bis 16, die wenigstens drei oder mehr Wandler-Strukturen (112, 114, 314, 506) in der Ausbreitungsrichtung der akustischen Welle umfasst.

18. Gekoppelte Hohlraumfilter-Struktur nach einem der Ansprüche 1 bis 17, wobei die Eigenschaften der piezoelektrischen Schicht (104) und der Elektroden (124, 126, 508, 510) der Wandler-Strukturen (112, 114, 314, 506) so gewählt werden, dass der elektromechanische Kopplungskoeffizient *kₛ²* der geführten Scherwelle oder der geführten Longitudinalwelle in der piezoelektrischen Schicht (104) über 5 % liegt.

19. Gekoppelte Hohlraumfilter-Struktur nach einem der Ansprüche 1 bis 18, wobei die Dicke der piezoelektrischen Schicht (104) so gewählt wird, dass der elektromechanische Kopplungskoeffizient *kₛ²* der geführten Scherwelle oder der geführten Longitudinalwelle in der piezoelektrischen Schicht (104) über 5 % liegt.

20. Gekoppelte Hohlraumfilter-Struktur nach einem der Ansprüche 1 bis 19, die des Weiteren eine dielektrische Schicht (108) umfasst, die zwischen dem Basissubstrat (106) und der piezoelektrischen Schicht (104) eingeschlossen ist.

21. Gekoppelte Hohlraumfilter-Struktur nach einem der Ansprüche 1 bis 20, wobei die piezoelektrische Schicht (104) Aluminiumnitrid (AIN), Zinkoxid (ZnO), PZT, Galliumnitrid (GaN), Lithiumtantalat LiTaO₃ oder Lithiumniobat LiNbO₃ mit einer kristallographischen Orientierung für Lithiumtantalat LiTaO₃ oder Lithiumniobat LiNbO₃, definiert als (YX*I*)/θ gemäß dem Standard IEEE 1949 Std-176, ist, wobei *θ*, ein Winkel der kristallographischen Orientierung, zwischen 0° und 60° oder zwischen 90° und 150°liegt.

22. Gekoppelte Hohlraumfilter-Struktur nach einem der Ansprüche 1 bis 21, wobei das Basissubstrat (106) des Verbundsubstrats (102) Silizium, Kohlenstoff-Diamant, Saphir, Quarz oder Siliziumkarbid ist.

23. Gekoppelte Hohlraumfilter-Struktur nach einem der Ansprüche 1 bis 22, wobei das Basissubstrat (106) einen Bragg-Spiegel unterhalb der piezoelektrischen Schicht (104) umfasst.

24. Gekoppelte Hohlraumfilter-Struktur nach einem der Ansprüche 1 bis 23, wobei der Filter-Bandpass zwischen 0,5 % und 10 % liegt.

25. Gekoppelte Hohlraumfilter-Struktur nach einem der Ansprüche 1 bis 24, die des Weiteren eine Passivierungsschicht umfasst, die über den Wandler-Strukturen (112, 114, 314, 506) und der wenigstens einen reflektierenden Struktur ausgebildet ist, wobei die Passivierungsschicht eine vorgegebene Dicke hat, die die gleiche ist wie die der Wandler-Strukturen (112, 114, 314, 506) und/oder der wenigstens einen reflektierenden Struktur oder sich von ihr unterscheidet.

## Revendications

1. Structure de filtre à cavités couplées utilisant une onde acoustique de surface guidée comprenant :
un substrat de propagation d'onde acoustique (102) ;
au moins une structure de transducteur d'entrée (112, 506) et une structure de transducteur de sortie (114, 506), disposées sur le substrat (102), chacune comprenant des électrodes en peigne imbriquées (124, 126, 508, 510),
une structure de réflexion (116), ladite structure de réflexion (116) comprenant au moins une ou plusieurs bandes métalliques (122), positionnées entre les structures de transducteur d'entrée et de sortie (112, 114, 506) à une distance d des structures de transducteur d'entrée et de sortie (112, 114, 506), dans la direction de propagation d'une onde acoustique,
**caractérisée en ce que**
le substrat de propagation d'onde acoustique (102) est un substrat composite comprenant un substrat de base (106) et une couche piézoélectrique (104), dans laquelle l'épaisseur de la couche piézoélectrique (104) est inférieure ou égale à 1,5 λ, dans laquelle λ est la longueur d'onde du mode fondamental de l'onde acoustique de surface guidée, et chaque zone (118) située entre ladite structure de réflexion (116) et chacune de la structure de transducteur d'entrée (112, 114, 506) et la structure de transducteur de sortie (112, 114, 506) respectivement, forme une cavité acoustique (120) avec sa largeur définie par la distance d*,*
et le filtre de cavité couplé est configuré de sorte que l'onde acoustique de surface guidée est une onde de cisaillement guidée ou une onde longitudinale guidée à l'intérieur de la couche piézoélectrique (104).

2. La structure de filtre à cavités couplées selon la revendication 1, dans laquelle les électrodes en peigne imbriquées (124, 126) de l'au moins une structure de transducteur d'entrée (112) et une structure de transducteur de sortie (114) sont définies par la condition de Bragg donnée par p = λ/2, λ étant la longueur d'onde acoustique de fonctionnement desdites structures de transducteur (112, 114) et p étant le pas d'électrode desdites structures de transducteur (112, 114) .

3. Structure de filtre à cavités couplées selon l'une des revendications 1 à 2, comprenant en outre au moins un miroir de Bragg (132, 134), installé à part de la structure de transducteur d'entrée et/ou de sortie (112, 114) sur le côté opposé du côté où l'une structure de réflexion (116) est installée, dans la direction de propagation de l'onde acoustique.

4. La structure de filtre à cavités couplées selon l'une des revendications 1 à 3, comprenant une pluralité de structures de réflexion séparées l'une de l'autre par un écart g et positionnées entre les structures de transducteur d'entrée et sortie (112, 114, 506) à une distance d de la structure de transducteur d'entrée et de sortie (112, 114, 506), dans la direction de propagation d'une onde acoustique, chaque écart g entre les structures de réflexion (116, 202, 204, 206, 208, 302, 304, 306, 308, 310, 312, 402, 404, 406 ) et chaque distance d entre une structure de transducteur (112, 114) et sa structure de réflexion voisine constituant une cavité acoustique (120, 212, 214, 316, 408).

5. La structure de filtre à cavités couplées selon l'une des revendications 1 à 4, dans laquelle la dimension de chaque cavité acoustique (120, 212, 214, 316, 408) est inférieure à λ/4.

6. La structure de filtre à cavités acoustiques selon l'une des revendications 1 à 5, dans laquelle la dimension de chaque cavité acoustique (120, 212, 214, 316, 408) est telle que la vélocité de phase dans la cavité acoustique (120, 212, 214, 316, 408) est supérieure à la vélocité de phase au sein de la structure de réflexion (116, 202, 204, 206, 208, 302, 304, 306, 308, 310, 312, 402, 404, 406).

7. La structure de filtre à cavités couplées selon l'une des revendications 4 à 6, dans laquelle les écarts g entre des structures de réflexion voisines (202, 204, 206, 208, 302, 304, 306, 308, 310, 312, 402, 404, 406) de la pluralité de structures de réflexion et/ou la distance d entre une structure de réflexion (116, 202, 204, 206, 208, 302, 304, 306, 308, 310, 312, 402, 404, 406) et une structure de transducteur voisine (112, 114, 506) sont identiques.

8. La structure de filtre à cavités couplées selon l'une des revendications 4 à 6, dans laquelle les écarts g entre des structures de réflexion voisines (202, 204, 206, 208, 302, 304, 306, 308, 310, 312, 402, 404, 406) de la pluralité de structures de réflexion et/ou la distance d entre une structure de réflexion (116, 202, 204, 206, 208, 302, 304, 306, 308, 310, 312, 402, 404, 406) et une structure de transducteur voisine (112, 114, 506) sont différents.

9. La structure de filtre à cavités couplées selon l'une des revendications 1 à 8, dans laquelle la structure de réflexion (116) ou les structures de réflexion (202, 204, 206, 208, 302, 304, 306, 308, 310, 312, 402, 404, 406) présente/présentent un coefficient de réflexion relatif à une bande métallique unitaire supérieur au coefficient de couplage *kₛ²* relative au substrat composite (102) et aux électrodes en peigne (124, 126, 604, 606) de la structure de transducteur (112, 114, 506) .

10. La structure de filtre à cavités couplées selon l'une des revendications 1 à 9, dans laquelle les structures de transducteur d'entrée et de sortie (112, 114, 506) présentent un nombre différent de tiges d'électrode (128, 130).

11. La structure de filtre à cavités couplées selon l'une des revendications 1 à 10, dans laquelle chaque structure de réflexion (116, 202, 204, 206, 208, 302, 304, 306, 308, 310, 312, 402, 404, 406) de la pluralité de structures de réflexion comprend des bandes métalliques (122, 210) avec un pas des bandes métalliques identique au pas d'électrode p des structures de transducteur d'entrée et de sortie (112, 114, 506) .

12. La structure de filtre à cavités couplées selon l'une des revendications 1 à 10, dans laquelle chaque structure de réflexion (116, 202, 204, 206, 208, 302, 304, 306, 308, 310, 312, 402, 404, 406) de la pluralité de structures de réflexion comprend des bandes métalliques (122, 210) avec un pas des bandes métalliques différent du pas d'électrode p des structures de transducteur d'entrée et de sortie (112, 114, 506) .

13. La structure de filtre à cavités couplées selon l'une des revendications 1 à 12, dans laquelle les bandes métalliques (124) de chaque structure de réflexion (116, 202, 204, 206, 208, 302, 304, 306, 308, 310, 312, 402, 404, 406) de la pluralité de structures de réflexion sont électriquement connectées l'une à l'autre.

14. La structure de filtre à cavités couplées selon l'une des revendications 1 à 13, dans laquelle le nombre de bandes métalliques (122, 210) de chaque structure de réflexion (116, 202, 204, 206, 208, 302, 304, 306, 308, 310, 312, 402, 404, 406) de la pluralité de structures de réflexion est inférieur à 30, de sorte que le coefficient de réflexion de la pluralité de structures de réflexion est supérieur à 0,5.

15. La structure de filtre à cavités couplées selon l'une des revendications 1 à 14, dans laquelle la différence entre l'impédance acoustique du matériau de la couche piézoélectrique (104) et du matériau des bandes métalliques (122, 210) de la pluralité de structures de réflexion est telle que le coefficient de réflexion de la pluralité de structures de réflexion est supérieur à 0,5.

16. La structure de filtre à cavités couplées selon l'une des revendications 1 à 15, dans laquelle les cavités acoustiques (120, 212, 214, 316, 408) sont divisées en sous-cavités (410) séparées l'une de l'autre.

17. La structure de filtre à cavités couplées selon l'une des revendications 1 à 16, comprenant au moins trois structures de transducteur (112, 114, 314, 506) ou plus dans la direction de propagation de l'onde acoustique.

18. La structure de filtre à cavités couplées selon l'une des revendications 1 à 17, dans laquelle les caractéristiques de la couche piézoélectrique (104) et des électrodes (124, 126, 508, 510) des structures de transducteur (112, 114, 314, 506) sont choisies de sorte que le coefficient de couplage électromagnétique kₛ² de l'onde de cisaillement guidée, ou de l'onde longitudinale guidée, dans la couche piézoélectrique (104) est supérieur à 5 %.

19. La structure de filtre à cavités couplées selon l'une des revendications 1 à 18, dans laquelle l'épaisseur de la couche piézoélectrique (104) est choisie de sorte que le coefficient de couplage électromagnétique kₛ² de l'onde de cisaillement guidée, ou de l'onde longitudinale guidée, dans la couche piézoélectrique (104) est supérieur à 5 %.

20. La structure de filtre à cavités couplées selon l'une des revendications 1 à 19, comprenant en outre une couche diélectrique (108), intercalée entre le substrat de base (106) et la couche piézoélectrique (104).

21. La structure de filtre à cavités couplées selon l'une des revendications 1 à 20, dans laquelle la couche piézoélectrique (104) est en nitrure d'aluminium (AlN), oxyde de zinc (ZnO), PZT, nitrure de gallium (GaN), tantalate de lithium LiTa0₃ ou niobate de lithium LiNb0₃ avec une orientation cristallographique pour le tantalate de lithium LiTa0₃ ou le niobate de lithium LiNb0₃ définie comme *(YX*/*)*/*θ* selon la norme IEEE 1949 Std-176, avec θ, un angle de l'orientation cristallographique compris entre 0 ° et 60 ° ou entre 90 ° et 150 °.

22. La structure de filtre à cavités couplées selon l'une des revendications 1 à 21, dans laquelle le substrat de base (106) du substrat composite (102) est un de silicium, de carbone diamant, de saphir, de quartz ou de carbure de silicium.

23. La structure de filtre à cavités couplées selon l'une des revendications 1 à 22, dans laquelle le substrat de base (106) comprend un miroir de Bragg sous la couche piézoélectrique (104).

24. La structure de filtre à cavités couplées selon l'une des revendications 1 à 23, dans laquelle le filtre passe-bande est compris entre 0,5 % et 10 %.

25. La structure de filtre à cavités couplées selon l'une des revendications 1 à 24 comprenant en outre une couche de passivation formée par-dessus des structures de transducteur (112, 114, 314, 506) et l'au moins une structure de réflexion, la couche de passivation présentant une épaisseur prédéterminée qui est identique ou différente par-dessus des structures de transducteur (112, 114, 314, 506) et/ou l'au moins une structure de réflexion.
